(19) Europäisches Patentamt
European Patent Office
Office européen des brevets

(11) **EP 0 744 798 A1**

(12) **EUROPÄISCHE PATENTANMELDUNG**

(43) Veröffentlichungstag:
27.11.1996 Patentblatt 1996/48

(51) Int. Cl.$^6$: **H01S 3/085**, H01S 3/025,
G02B 6/42

(21) Anmeldenummer: 96107240.2

(22) Anmeldetag: 08.05.1996

(84) Benannte Vertragsstaaten:
**CH DE ES FR GB IT LI SE**

(30) Priorität: 24.05.1995 DE 19519059

(71) Anmelder: **ROBERT BOSCH GMBH**
**70442 Stuttgart (DE)**

(72) Erfinder:
• **Kuke, Albrecht, Dr.Dr.-Ing.**
**71549 Auenwald (DE)**
• **Schwander, Thomas, Dipl.-Ing.**
**71522 Backnang (DE)**
• **Schmitt, Reinhold, Dr.rer.nat.Dipl.-Phys.**
**71546 Aspach (DE)**
• **Hirth, Helmut, Dr.Dr.rer.nat.**
**71522 Backnang (DE)**

(54) **Anordnung zur Ankopplung eines Lasers**

(57) Zur Anpassung des Strahlungsfeldes des Lichts aus einem Laser an das einer anderen optischen Komponente, beispielsweise einer Faser, sind Linsen notwendig, die zwischen Laser und Faser mit hoher Justiergenauigkeit angebracht werden müssen.

Durch die erfindungsgemäße Anordnung wird eine Justage zwischen Laser und Linse vermieden. Ein Laser (1) mit verteilter Rückkopplung, der aus einem Substrat und aus auf der Oberseite des Substrats angeordneten Epitaxieschichten mit einer aktiven Zone (2) besteht, weist an zumindest einer Stirnseite der aktiven Zone (2) als Begrenzung eine geneigte Seitenfläche (4) auf. Auf der Unterseite des Substrats ist eine Linse (5) ausgebildet. Das an der Seitenfläche (4) reflektierte Licht aus der aktiven Zone wird an der Linse (5) kollimiert, wenn es aus dem Substrat austritt.

Fig. 1

EP 0 744 798 A1

## Beschreibung

Stand der Technik

Die Erfindung betrifft eine Anordnung zur Ankopplung eines Lasers mit einem Laser mit verteilter Rückkopplung, der aus einem Substrat und aus auf der Oberseite des Substrats angeordneten Expitaxieschichten mit einer aktiven Zone besteht.

Halbleiterlaser senden typischerweise ein Lichtbündel mit einem elliptischen gaußförmigen Profil aus, das beim Austritt in Luft einen großen Öffnungswinkel besitzt, der im allgemeinen wesentlich größer ist als der Aperturwinkel einer Einmodenfaser. Nach der gaußschen Strahltheorie sind der Öffnungswinkel des Strahlbündels und der Radius der Strahltaille umgekehrt proportional zueinander, d.h. daß die Halbmesser der Strahltaillenellipse des Lasers wesentlich kleiner sind als der Strahltaillenradius einer Einmodenfaser. Typische Werte sind 0,5 $\mu$m und 1,5 $\mu$m für die Taillenhalbmesser eines Lasers und 5 $\mu$m für den Taillenradius der Faser. Bei einer direkten Stoßkopplung zwischen einem Halbleiterlaser und einer Einmodenfaser lassen sich daher nur Koppelwirkungsgrade zwischen 10 % und 15 % erreichen. Nach dem Stand der Technik werden verschiedene Methoden angewandt, um das Feld des Lasers an das Feld der Faser anzupassen und dadurch den Koppelwirkungsgrad zu erhöhen.

Eine Methode besteht darin, daß das Feld im Laser selbst aufgeweitet wird, was nach der gaußschen Strahltheorie zu einem kleineren Öffnungswinkel des abgestrahlten Lichtbündels führt. Dies bereitet aber noch technologische Schwierigkeiten, da hierbei der Wellenleiter im Laser nicht nur in seiner Breite sondern auch in seiner Dicke kontinuierlich verändert werden muß.

Eine andere Möglichkeit besteht darin, das Feld der Faser an das des Lasers anzupassen. Dies läßt sich technologisch leichter erreichen, indem die Faser an ihrem Ende unter Erwärmung ausgezogen wird und an ihre Stirnfläche eine Linse angeschmolzen wird. Ein Nachteil dieser Methode besteht darin, daß hierbei die Koppeltoleranzen klein gegenüber der Feldausdehnung des Lasers sein müssen, d.h. die Koppeltoleranz liegt im Zehntelmikrometerbereich, während bei der Kopplung in der Strahltaille der Faser Toleranzen von wenigen Mikrometern zulässig sind.

Eine weitere Möglichkeit zur Feldanpassung besteht in der Verwendung von ein oder zwei diskreten optischen Linsen, mit denen die Strahltaille des Lasers auf die Größe der Strahltaille der Faser vergrößert wird. Bei dieser Methode ist noch mindestens ein Justageschritt, der wegen der größeren Toleranzen zweckmäßigerweise in der Ebene der Faserstrahltaille durchgeführt wird, erforderlich. Will man die Lage der Faser in bezug auf die Abbildungslinsen z.B. durch mikromechanische Halterungen festlegen, so daß eine Faserjustage entfallen kann, so muß die Position der Laserstrahltaille in bezug auf die Abbildungsoptik mit einer Genauigkeit im Submikrometerbereich definiert sein. Dies ist bisher ohne aktive Justage nicht möglich.

Es ist Aufgabe der Erfindung, eine Anordnung zur Ankopplung eines Lasers mit einem weiteren optischen Element, beispielsweise einer Faser anzugeben, die einen erhöhten Koppelwirkungsgrad aufweist.

Die Aufgabe wird durch eine Anordnung mit den Merkmalen des Patentanspruchs 1 gelöst. Vorteilhafte Weiterbildungen sind in den Unteransprüchen angegeben.

Die vorliegende Anordnung gibt eine Möglichkeit an, die es erlaubt, die gegenseitige Position der Laserstrahltaille und einer Abbildungslinse mit sehr hoher Genauigkeit zueinander zu positionieren, wobei die Vorteile der Maskentechnik genutzt werden. Ein weiterer Vorteil dieser Technik ist, daß die gegenseitige Ausrichtung von Strahltaille und Linse für alle Bauelemente eines Wafers gleichzeitig erreicht wird, wodurch im Vergleich zur Einzeljustage eines jeden Bauteils neben der größeren Genauigkeit auch ein bedeutender Kostenvorteil erreicht wird. Ein weiterer Vorteil der erfindungsgemäßen Lösung besteht darin, daß die einzelnen Laser während des Herstellungsprozesses schon auf dem Wafer in ihrer Lichtleistung gemessen werden können, bevor sie vereinzelt sind. Dies ist bei normalen Lasern bisher nicht möglich, da diese an einer Spaltfläche abstrahlen, die erst beim Vereinzeln entsteht.

Ein Ausführungsbeispiel der Erfindung wird anhand der Zeichnungen erläutert. Es zeigen:

Figur 1 einen Schnitt durch einen Laser, der an eine Faser angekoppelt ist und
Figur 2 eine Detaildarstellung der V-Nut auf der Oberseite des Lasers.

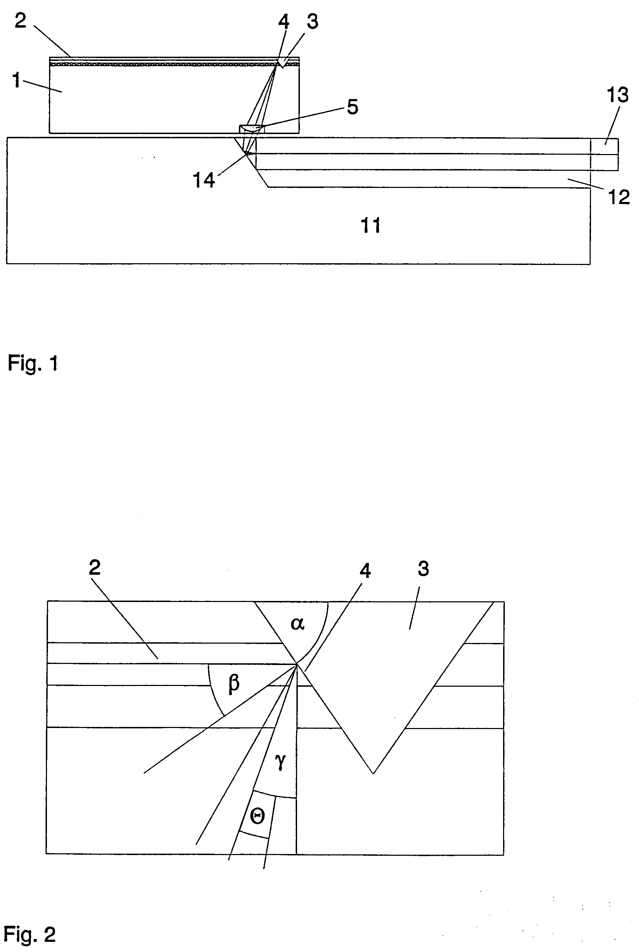

Ein Laserchip 1 weist auf seiner Oberseite die Epitaxieschichten mit der aktiven Laserzone 2 auf. Die aktive Laserzone 2 wird an mindestens einer Seite durch eine Seitenfläche einer V-Nut abgeschlossen. Die Flächennormale der der aktiven Zone zugewandten Seitenfläche 4 schließt mit der Ebene der aktiven Zone einen Winkel $\beta$ ein (Bezeichnung der Winkel siehe Detailskizze in Fig. 2). Wenn der Winkel $\beta$ größer ist als der Grenzwinkel der Totalreflexion, so wird das Licht aus der aktiven Zone unter einem Winkel von 2$\beta$ in das Substrat des Laserchips 1 hineinreflektiert. Ist der Winkel $\beta$ kleiner als der Grenzwinkel der Totalreflexion, so muß eine Reflexionsschicht auf der Seitenfläche 4 der V-Nut 3 aufgebracht werden. Bei einem Halbleiterlaser auf InP-Basis mit einem Brechungsindex von 3,2 beträgt der Grenzwinkel der Totalreflexion etwa 18°, das heißt, daß bei einem Böschungswinkel $\alpha$ <= 72° der Seitenfläche der V-Nut eine Reflexionsbeschichtung nicht erforderlich ist. Wählt man einen Böschungswinkel der Seitenfläche von $\alpha$ = 45°, so wird das aus der aktiven Zone austretende Lichtbündel gerade senkrecht in das Substrat hineinreflektiert. Eine solche V-Nut läßt sich beispielsweise durch Trockenätzen mit Ionenstrahlen unter Maskierung der Laseroberseite außerhalb der V-Nut bei schräger Einstrahlrichtung erreichen. Eine andere Möglichkeit zur Herstellung der V-Nut 3 bietet die anisotrope Ätztechnik, die ähnlich wie im Silizium auch in InP und darauf aufgebrachten Epitaxieschichten möglich ist. Hier beträgt der Böschungswinkel $\alpha$ = arctan($\sqrt{2}$) = 54,7° . Dieser Winkel ist durch die Kristallstruktur vorgegeben und kann deshalb mit sehr hoher Präzision reproduzierbar erreicht werden. In diesem Fall wird der Strahl um einen Winkel von $\delta$ = 90-2*$\alpha$ = 19,5° zur Normalen der Halbleiteroberfläche in das Substrat des Lasers hineingebrochen. Die Nut muß nicht wie beim angegebenen Beispiel V-förmig sein. Es genügt, daß die der aktiven Laserzone 2 zugewandte Seitenfläche geneigt ist. Der Laser kann auch gar keine Nut sondern eine abgeschrägte Ecke aufweisen. Da bei der erfindungsgemäßen Lösung an mindestens einer Begrenzung der laseraktiven Zone kein senkrechter Spiegel vorliegt, kann hier nicht ein Laser vom Fabry-Perot-Typ eingesetzt werden, sondern es muß ein Laser mit verteilter Rückkopplung wie z.B. ein DFB-Laser oder ein DBR-Laser Anwendung finden.

Das an der Seitenfläche der V-Nut reflektierte Strahlbündel breitet sich als gaußscher Freistrahl im Substrat des Halbleiterlasers aus. Die Strahltaille liegt dabei in der Reflexionsstelle auf der Seitenfläche der V-Nut. Im Unterschied zur Freistrahlausbreitung in den Luftraum, wie bei herkömmlichen Halbleiterlasern, ist bei der Freistrahlausbreitung im Lasersubstrat der Öffnungswinkel entsprechend der höheren Brechzahl im Substrat des Halbleiterlasers geringer. Bei einem Taillenradius von $w_{x0}$ beträgt der Öffnungsbündel $\Theta$ eines gaußschen Strahls in einem Medium mit der Brechzahl n.

$$\Theta = \text{arctan} \ (\lambda/n^*\pi^*w_{x0}) \qquad (1)$$

Ein Laser, der in Luft mit einem Öffnungswinkel von 30° strahlen würde, hätte in einem InP-Substrat ($n_s$ = 3,2) nur einen Öffnungswinkel von 10°.

Erfindungsgemäß wird an der Stelle auf der Chipunterseite, in der der Strahl aus dem InP austritt, eine Linse 5 angebracht. Diese Linse kann auf verschiedene Weise hergestellt werden. Vorzugsweise wird ein Herstellungsverfahren für die Linse gewählt, bei welchem die Position der Linse durch Maskentechnik bestimmt wird, damit die gegenseitige Position der Strahltaille auf der Seitenfläche 4 und der Linsenmitte mit möglichst hoher Präzision festgelegt werden kann. So lassen sich beispielsweise Linsen durch ein Trockenätzverfahren mit Ionenstrahlen herstellen, bei welchem die nicht zu ätzenden Teile abgedeckt werden. Die Form der Linse wird dabei durch die Dicke des Abdeckmaterials bestimmt, welches während des Ätzprozesses selbst mit angegriffen wird. Andere Linsen, bei denen die Position durch Maskentechnik hochgenau festgelegt werden kann, sind beispielsweise holografische Linsen bder Fresnellinsen. Auch Linsen, die durch Belichtung einer auf der Chipunterseite aufgebrachten lichtempfindlichen Schicht hergestellt werden, sind geeignet. Besonders vorteilhaft sind solche Linsen, wenn zur Belichtung das Laserlicht selbst benutzt werden kann, da dann eine Selbstpositionierung der Linse möglich ist.

Die Brennweite der Linse 5 kann durch geeignete Formgebung entweder so gewählt werden, daß die Strahltaille auf der Seitenfläche 5 gerade in der Brennebene der Linse liegt. In den Außenraum tritt dann ein kollimierter Strahl aus, dessen Richtung durch die gegenseitige Position der Strahltaille und der Linsenmitte bestimmt ist. Dieser kollimierte Strahl kann über weitere optische Abbildungs- und Umlenkelemente auf eine Faser gelenkt werden. Die Linse 5 kann aber auch eine höhere Brechkraft haben, so daß ihre Brennweite kleiner ist als der Abstand zwischen Linse und Strahltaille. Dann tritt aus der Linse ein fokussierter Strahl aus, der bei geeigneter Wahl der Vergrößerung M = Bildweite/Gegenstandsweite direkt in die Faser eingekoppelt werden kann. Für die Montage des Lasers und der Faser ist es dabei vorteilhaft, wenn die Faser parallel zur Montagefläche des Lasers geführt werden kann. In der Fig. 1 ist ein Ausführungsbeispiel dargestellt, bei welchem als Montageplattform für den Laserchip ein Siliziumsubstrat 11 dient. Der Laser trägt auf seiner Unterseite eine Mikrolinse 5, die so dimensioniert ist, daß der aus der Linse austretende Strahl fokussiert ist, wobei die Linse die Strahlanpassung entsprechend den unterschiedlichen Taillenradien im Halbleiterlaser und in der Faser durchführt. Im Siliziumsubstrat 11 ist mit den bekannten Methoden der mikromechanischen Ätztechnik eine V-Nut 12 anisotrop geätzt, die eine Faser 13 trägt. Die Stirnfläche 14 der V-Nut ist verspiegelt. Da die Stirnfläche 14 ebenso wie die Seitenfläche 4 bei der Herstellung durch anisotrope Ätztechnik durch eine (111)-Ebene gebildet werden, sind beide Flächen parallel zueinander. Daraus folgt, daß der Mittelstrahl des an der Stirnfläche 14 reflektierten Strahlbündels genau in Richtung der Faserachse verläuft, was für eine optimale Strahleinkopplung erforderlich ist.

Bei dieser Abbildung wird die besonders kritische Toleranz für die gegenseitige Position der Strahltaille im Laser und der Linse durch hochgenaue Maskentechnik auf dem Wafer bei der Laserherstellung erreicht. Die weniger kritische Toleranz in der Strahltaille der Faser wird durch die Lagegenauigkeit des Laserchips in bezug auf die in das Silizium eingeätzte V-Nut erreicht. Zur lagegenauen Positionierung des Laserchips zur V-Nut 12 können ebenfalls anisotrop geätzte Anschlagstrukturen auf dem Silizium-Wafer dienen.

Da das Licht auf der Waferunterseite des Laserwafers austritt, können alle Laser auf einem Wafer schon vor der Vereinzelung getestet werden. Einzelne Laser, die nicht in Ordnung sind, können so frühzeitig aus dem Fertigungsprozeß ausgeschieden werden, was zu einer Kostensenkung des Gesamtprozesses beiträgt.

**Patentansprüche**

1. Anordnung zur Ankopplung eines Lasers mit einem Laser (1) mit verteilten Rückkopplung, der aus einem Substrat und aus auf der Oberseite des Substrats angeordneten Expitaxieschichten mit einer aktiven Zone (2) besteht, dadurch gekennzeichnet, daß die aktive Zone (2) an zumindest einer Stirnseite durch eine geneigte Seitenfläche (4) begrenzt ist, die derart geneigt ist, daß das Licht aus der aktiven Zone Totalreflexion erfährt oder die mit einer Beschichtung verspiegelt ist und daß auf der der Oberseite gegenüberliegende Unterseite des Lasers (1) im Substrat eine Linse (5) ausgebildet ist, derart, daß das an der Seitenfläche (4) reflektierte Licht von der Linse (5) kollimiert wird, wenn es aus dem Substrat austritt.

2. Anordnung nach Anspruch 1, dadurch gekennzeichnet, daß die geneigte Seitenfläche (4) eine Seitenfläche einer anisotrop geätzten V-Nut(3) ist.

3. Anordnung nach einem der Ansprüche 1 oder 2, dadurch gekennzeichnet, daß die Linse (5) durch Trockenätzverfahren hergestellt ist.

Fig. 1

Fig. 2

Europäisches
Patentamt

# EUROPÄISCHER RECHERCHENBERICHT

Nummer der Anmeldung

EP 96 10 7240

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | PATENT ABSTRACTS OF JAPAN vol. 9, no. 284 (E-357) [2007] , 12.November 1985 & JP-A-60 124983 (NIPPON DENKI K.K.), 4.Juli 1985, * Zusammenfassung * | 1 | H01S3/085 H01S3/025 G02B6/42 |
| Y | --- | 2,3 | |
| Y | IEEE PHOTONICS TECHNOLOGY LETTERS, Bd. 3, Nr. 9, September 1991, NEW YORK US, Seiten 776-778, XP000225787 B. STEGMÜLLER ET AL.: "SURFACE EMITTING INGAASP/INP DISTRIBUTED FEEDBACK LASER DIODE AT 1.53 MICROMETER WITH MONOLITHIC INTEGRATED MICROLENS" * das ganze Dokument * | 2 | |
| A | --- | 1,3 | |
| Y | PATENT ABSTRACTS OF JAPAN vol. 12, no. 425 (E-681) [3272] , 10.November 1988 & JP-A-63 164386 (MATSUSHITA ELECTRIC IND CO LTD), 7.Juli 1988, * Zusammenfassung * | 3 | |
| A | --- | 1,2 | |
| A | APPLIED PHYSICS LETTERS, Bd. 56, Nr. 13, 26.März 1990, NEW YORK US, Seiten 1219-1221, XP000133192 Z.L. LIAU ET AL.: "GAINASP/INP BURIED-HETEROSTRUCTURE SURFACE-EMITTING DIODE LASER WITH MONOLITHIC INTEGRATED BIFOCAL MICROLENS" * das ganze Dokument * --- | 1-3 | |

**RECHERCHIERTE SACHGEBIETE (Int.Cl.6)**

H01S
G02B

-/--

Der vorliegende Recherchenbericht wurde für alle Patentansprüche erstellt

| Recherchenort | Abschlußdatum der Recherche | Prüfer |
|---|---|---|
| DEN HAAG | 4.September 1996 | Horak, G |

| Europäisches Patentamt | EUROPÄISCHER RECHERCHENBERICHT | Nummer der Anmeldung EP 96 10 7240 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | DE-A-28 20 646 (NORTHERN TELECOM LTD.) 25.Januar 1979 * Seite 5, Zeile 1 - Seite 6, Zeile 9; Abbildungen 2,4,7 * --- | 1-3 | |
| A | PATENT ABSTRACTS OF JAPAN vol. 11, no. 314 (E-549) [2761] , 13.Oktober 1987 & JP-A-62 106686 (MATSUSHITA ELECTRIC IND CO LTD), 18.Mai 1987, * Zusammenfassung * --- | 1 | |
| A | US-A-4 935 939 (Z.-L. LIAU ET AL.) 19.Juni 1990 * Spalte 1, Zeile 11 - Spalte 2, Zeile 32; Abbildungen 2,4-7 * --- | 1,3 | |
| X,P | EP-A-0 658 784 (SIEMENS AKTIENGESELLSCHAFT) 21.Juni 1995 * Zusammenfassung * * Spalte 2, Zeile 18 - Spalte 3, Zeile 35; Abbildungen 1,2,4 * ----- | 1,2 | RECHERCHIERTE SACHGEBIETE (Int.Cl.6) |

Der vorliegende Recherchenbericht wurde für alle Patentansprüche erstellt

| Recherchenort | Abschlußdatum der Recherche | Prüfer |
|---|---|---|
| DEN HAAG | 4.September 1996 | Horak, G |

EPO FORM 1503 03.82 (P04C03)